# EUROPEAN PATENT APPLICATION

(11) **EP 4 498 773 A2**
(43) Date of publication of application: **29.01.2025**
(21) Application number: 24190762.5
(22) Date of filing: 24.07.2024
(51) Int. Cl.: H05K 7/14

(54) **POWER DISTRIBUTION UNIT WITH DIN-RAIL BREAKER PANEL MOUNT**

(30) Priority: 28.07.2023 US 202363516257 P
(71) Applicant: Vertiv Corporation, Westerville, OH 43082 (US)
(72) Inventor: PREUSS, Jesse, Lincoln, 68523 (US); NGUYEN, Quang, Lincoln, 68516 (US); THOMAS, Caleb, Lincoln, 68524 (US)
(74) Representative: Bryn-Jacobsen, Caelia

(57) **Abstract**

The present disclosure is directed to a power distribution unit (PDU). The PDU includes an enclosure, which consists of a front panel, at least one side panel, and a rear panel. The PDU further includes at least one power output receptacle mounted on the enclosure, and at least one or more circuit breakers coupled to a breaker mount. The circuit breaker can have a DIN-Rail mount design and is in series with the corresponding power outlet receptacle. The breaker mount consists of a base surface, a mounting surface, and a top surface for attaching the breaker mount to the PDU. The mounting surface of the breaker mount includes a first mounting post and a second mounting post, to allow for a DIN-Rail mountable circuit breaker to be installed in the PDU.

## Description

### BACKGROUND

The present invention relates to rack mounted power distribution units, and more particularly, this invention relates to a panel mount to allow additional types of circuit breakers to be implemented into rack power distribution units.

Computer servers are essential components of data centers, providing the computational power and storage required for various applications. In order to provide power to these computer servers, power distribution units (PDU) are often located near servers. PDUs are devices that are designed to distribute electrical power efficiently and safely from a primary power source to multiple electronic devices or equipment within data centers, industrial settings, office spaces, and various other applications. Traditional PDUs typically consist of a housing with multiple electrical outlets or receptacles that allow users to connect multiple devices. These PDUs are connected to a primary power source, such as a utility supply or an uninterruptible power supply (UPS). PDUs serve as the intermediary between the power source and the electronic equipment, such as computer servers.

PDUs rely on circuit breakers as crucial safety components. Circuit breakers play a vital role in protecting electrical systems from potential risks, such as overcurrent, short circuits, and other electrical faults. By promptly stopping the current flow when irregularities occur, circuit breakers prevent damage to equipment, reduce the risk of fires, and ensure the safety of those persons who handle the equipment. While conventional circuit breakers may be effective in PDUs, the continued innovation of PDUs and increasing needs for more robust uninterruptable power call for additional resources to incorporate a variety of types of circuit breakers into PDUs.

Most modern circuit breakers are designed with a DIN-Rail mounting package. DIN-Rail mounts serve as standardized mounting platforms, facilitating the installation and organization of various electrical devices within control panels and distribution boards. Their universal design enables easy installation, replacement, and reconfiguration of circuit breakers, enhancing overall flexibility and ease of maintenance. The integration of circuit breakers with DIN-Rail mounts streamlines electrical system installations, making them more efficient, cost-effective, and adaptable to a wide range of applications in modern electrical engineering. DIN-Rail mounted circuit breakers are typically not used in rack PDUs because access to the actuator of the breaker is needed to be presented out of the face of the unit.

In light of the above, there exists a need for a rack PDU that allows for the use of DIN-Rail mount circuit breakers instead of traditional PDU circuit breakers. The present approach aims to provide a solution for this need by introducing a circuit breaker panel mount that may be fixed within a standard rack PDU. This panel mount allows for circuit breakers with DIN-Rail mount tooling to be installed and used in a rack PDU. The novel design of this panel mount allows for a more diverse selection of circuit breakers to be used in a rack PDU, resulting in reductions of cost, improving manufacturing capabilities, and additional electrical capabilities of rack PDUs.

### BRIEF DESCRIPTION OF THE DRAWINGS

The detailed description is described with reference to the accompanying figures.
FIG. 1 illustrates a front orthogonal view of a power distribution unit (PDU);
FIG. 2 illustrates an orthogonal view of a DIN-Rail breaker mount;
FIG. 3 illustrates a rear orthogonal view of the PDU of Fig. 1, with the DIN-Rail breaker mount of Fig. 2; and
FIG. 4 illustrates a top view of the PDU of Fig. 1, with the DIN-Rail breaker mount of Fig. 2.

### SUMMARY

The present invention is set out in the independent claims, with some optional features set out in the claims dependent thereto.

In an example, the present disclosure is directed to a power distribution unit (PDU). The PDU includes an enclosure, which consists of a front panel, at least one side panel, and a rear panel. The PDU further includes at least one power output receptacle mounted on the enclosure, and at least one or more circuit breakers coupled to a breaker mount. The circuit breaker may have a DIN-Rail mount design and is in series with the corresponding power outlet receptacle.

In an example, the present disclosure is directed to a breaker mount for mounting a circuit breaker to a front panel of a power distribution unit. The breaker mount includes a base, a mounting surface, and a top surface. The base includes a left and right mounting tab, a left and right mounting hole, a base cavity that may cool a circuit breaker, and a base connection piece that connects the left and right mounting tab. The mounting surface includes a first mounting post, a second mounting post, and a mounting cavity between the first and second mounting post that allows a circuit breaker to be air cooled. The top surface includes a top mounting tab and a top mounting hole for mounting the breaker mount to the PDU. The top surface further includes a top cavity to enable air cooling of a mounted circuit breaker.

These and other features and aspects may be better understood with reference to the following drawings, description, and appended claims.

### DETAILED DESCRIPTION

Aspects of the disclosure are described more fully hereinafter with reference to the accompanying drawings, which form a part hereof, and which show, by way of illustration, example features. The features may, however, be embodied in many different forms and should not be construed as limited to the combinations set forth herein; rather, these combinations are provided so that this disclosure will be thorough and complete and will fully convey the scope. The following detailed description is, therefore, not to be taken in a limiting sense.

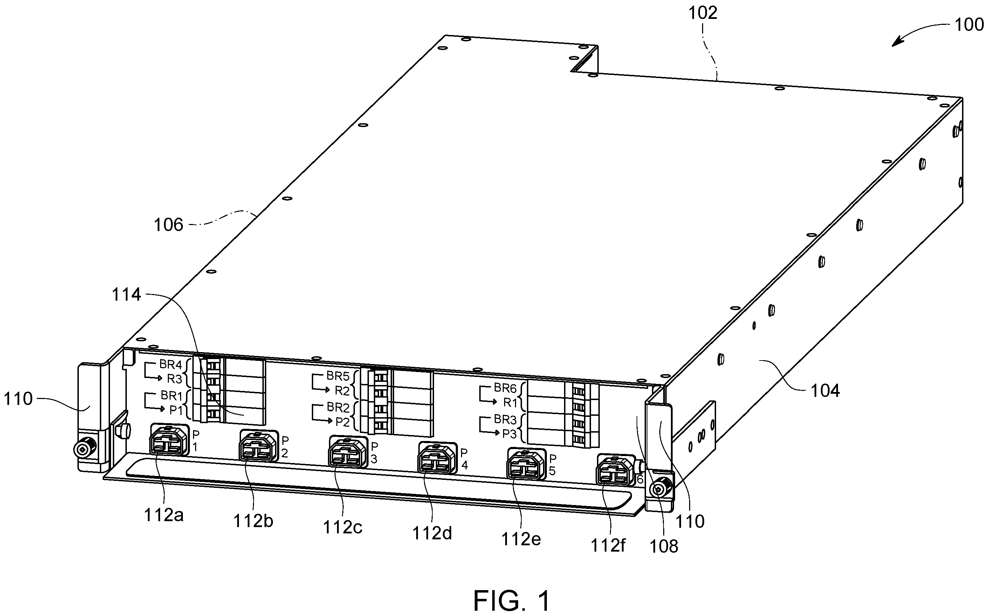

Shown throughout the figures, the present disclosure is directed towards a rack-mounted power distribution unit (PDU) with a circuit breaker panel mount that allows for a DIN rail mountable circuit breaker to be used in the PDU. Referring initially to FIG. 1, a PDU 100 is illustrated in accordance with an exemplary example of the present disclosure.

FIG. 1 is a front orthogonal view illustrating a PDU 100 in an open position according to one example. The PDU 100 includes a rear panel 102, a right side panel 104, a left side panel 106, and a front panel 108. The PDU 100 may further include at least one rack mounting tab 110. The rack mounting tab 110 is configured to engage with a rack. In an example, the PDU 100 may be considered a rack PDU (rPDU), wherein the rack PDU is mounted in a traditional server rack using at least one mounting tab 100. The PDU 100 also includes circuit breakers 114. Circuit breakers 114 may be of the DIN-rail type. As depicted, circuit breakers 114 include user accessible actuators which are presented and extent out from the front panel 108. The actuators may have a first position for a closed circuit, a second position indicating an overloaded and thus open circuit, and a third position indicating a reset position. The presentation of actuators allows a user to operate the individual circuit breakers 114 and is a desirable feature for PDU 100. DIN-rail type circuit breakers may be typically found for higher amperage ratings, which are required to support higher power densities.

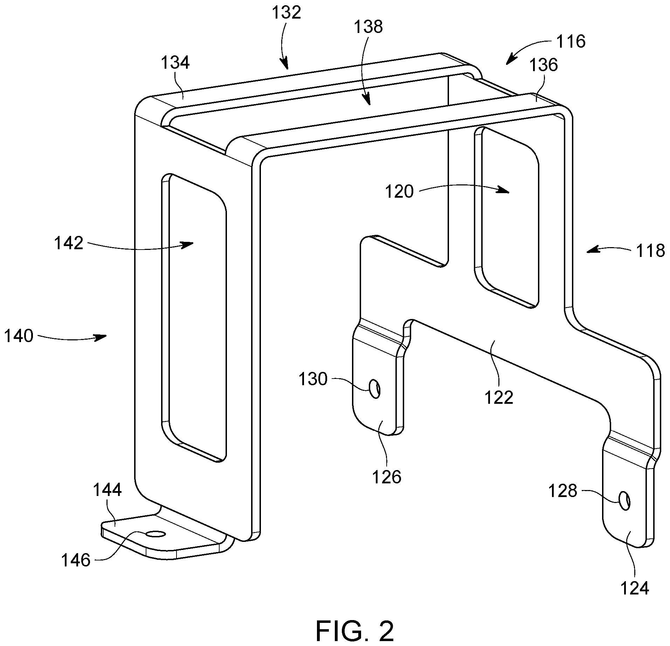

FIG. 2 is an orthogonal view illustrating a DIN-Rail breaker mount 116 in accordance with the present invention. The DIN-Rail breaker mount 116 may be manufactured using materials that may be bent, molded, or machined. However, a typical material for a DIN-Rail breaker mount may be steel or aluminum. The DIN-Rail breaker mount 116 includes a top surface 118. The top surface 118 may have a height of approximately 61mm and a width of approximately 60mm (2.35 inches). The top surface 118 includes a top cavity 120. The top cavity 120 allows air to flow on both sides of the top surface 118. When a circuit breaker 114 is mounted in the DIN-Rail breaker mount 116, the air flowing in and around the top cavity 120 may cool the circuit breaker 114. The top surface 118 further includes a top connection piece 122, a left mounting tab 124, and a right mounting tab 126. The left mounting tab 124 and the right mounting tab 126 extend outwardly from the DIN-Rail breaker mount 116 on opposing ends of the top connection piece 122. Each of the left mounting tab 124 and the right mounting tab 126 have a width of approximately 13mm (0.50 inches). The right mounting tab 124 may include a right mounting hole 128. The left mounting tab 126 may include a left mounting hole 130. The right mounting hole 128 and the left mounting hole 130 may be used to align the DIN-Rail breaker mount 116 to the front panel 108 of the PDU 100. A screw may be inserted through the mounting holes 128, 130 and into the front panel 108 to secure the DIN-Rail breaker mount 116 to the PDU 100. The diameter of each of the mounting holes 128, 130 is approximately 2.8mm (0.11 inches).

FIG. 2 further illustrates that a DIN-Rail breaker mount 116 which may include a mounting surface 132. The mounting surface 132 includes a first mounting post 134, a second mounting post 136, and a mounting cavity 138. As illustrated in the exemplary example, the mounting cavity 138 is the space between the first mounting post 134 and the second mounting post 136. When a circuit breaker is mounted in the DIN-Rail breaker mount 116, the air flowing in and around the mounting cavity 138 may cool the mounted circuit breaker. One of ordinary skill in the art would understand that the dimensions and alignment of the first mounting post 134 and the second mounting post 136 resemble closely that of a standard DIN-Rail mount. As depicted in the exemplary example, the length of each of the first mounting post 134 and the second mounting post 136 is approximately 54mm (2.10 inches), which closely replicates that of a DIN-rail. The distance between the first mounting post 134 and the second mounting post 136 is approximately 20mm (0.78 inches). However, the dimensions and alignment of the first mounting post 134 and the second mounting post 136 are not limited to only that of a standard DIN-Rail mount, the mounting posts 134, 136 may be aligned to accommodate any type of circuit breaker mounting system.

FIG. 2 further illustrates that a DIN-Rail breaker mount 116 may include a base surface 140. The base surface 140 includes a base cavity 142, a base mounting tab 144, and a base mounting hole 146. The length of the base surface 140 is approximately 62mm (2.45 inches) and the width of the base surface 140 is approximately 35mm (1.37 inches). The base cavity 142 is formed in the center of the base surface 140. When a circuit breaker is mounted in the DIN-Rail breaker mount 116, the air flowing in and around the base cavity 142 may cool the circuit breaker. As illustrated in the exemplary example, the base mounting tab 144 extends outwardly, approximately 13mm (0.5 inches), from the base surface 140 at an approximate 90-degree angle. The base mounting tab 144 includes a base mounting hole 146. The base mounting hole 146 has a diameter of approximately 2.8mm (0.11 inches) and may be used to align the DIN-Rail breaker mount 116 to the front panel 108 of the PDU 100. A screw may be inserted through the base mounting hole 146 and into the front panel 108 to secure the DIN-Rail breaker mount 116 to the PDU 100.

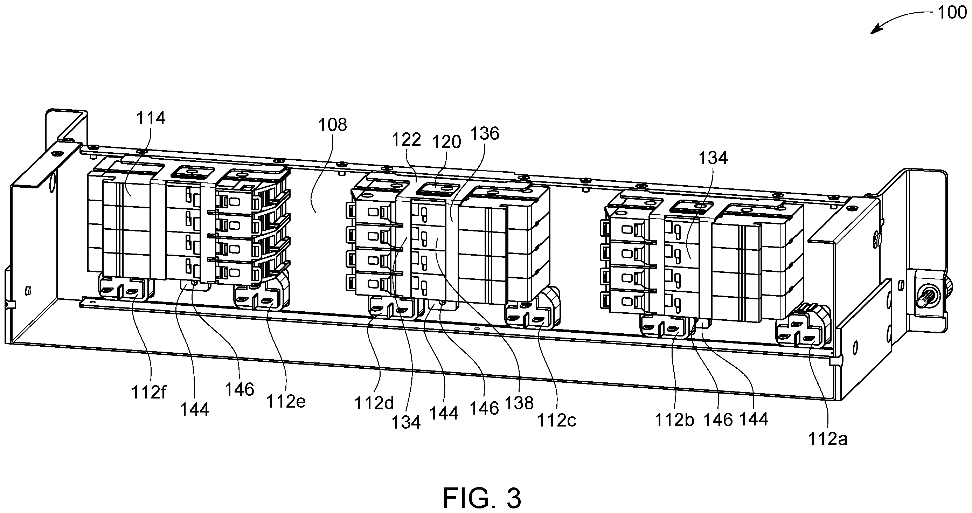

FIG. 3 illustrates a rear orthogonal view of the PDU 100 and the DIN-Rail breaker mount 116, in accordance with an exemplary example. A circuit breaker 114 is shown mounted within the DIN-Rail breaker mount 116. In the exemplary example, four circuit breakers are mounted within the DIN-Rail breaker mount 116. One of ordinary skill in the art would identify that the illustrated circuit breakers 114 are considered "one pole" circuit breakers. As depicted in the exemplary example, a "one pole" circuit breaker has a width ranging from 12mm to 13mm (0.48 to 0.52 inches). Therefore, four "one pole" circuit breakers, with a combined width of 48mm to 52mm (1.8 to 2.1 inches), may be mounted within the DIN-Rail breaker mount 116. However, other size circuit breakers may be mounted within the DIN-Rail breaker mount 116. Two, "two pole" circuit breakers would fit within the DIN-Rail breaker mount, and a single "four pole" circuit breaker would fit within the DIN-Rail breaker mount. Therein lies a notable benefit of the present invention, the DIN-Rail breaker mount 116 allows a variety of circuit breakers to be used with a rack PDU, rather than traditional panel style circuit breakers.

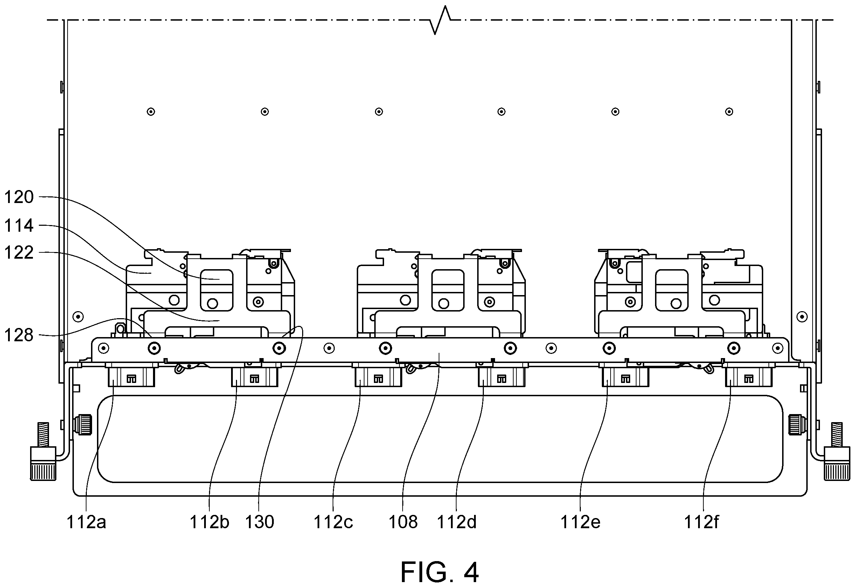

FIG. 4 illustrates a top view of the PDU 100 and the DIN-Rail breaker mount 116, in accordance with an exemplary example. The DIN-Rail breaker mount 116 may be mounted to the front panel 108 via a screw through the left mounting hole 128 and the right mounting hole 130. Fig. 4 further shows that the circuit breaker 114 may be aligned with each of its respective power outlet receptacle 112.

Further examples are set out in the clauses below:
1. A power distribution unit comprising:
   an enclosure, comprising: a front panel;
   a first power output receptacle mounted on the enclosure; and
   a first circuit breaker mount is coupled to the front panel of the enclosure.
2. The PDU of any one of the preceding clauses wherein the first circuit breaker mount includes a
   mounting surface comprising a first mounting post and a second mounting post
   wherein the first and second mounting posts are spaced apart.
3. The PDU of one of the preceding clauses wherein the first and second mounting posts are spaced apart to receive a circuit breaker having a standard DIN-Rail mount.
4. The PDU of one of the preceding clauses wherein the mounting surface further includes a mounting cavity formed by the space between the first and second mounting posts.
5. The power distribution unit of one of the preceding clauses, further including a first circuit breaker electrically coupled to the first power output receptacle, the first circuit breaker being physically coupled to first circuit breaker mount.
6. The power distribution unit of one of the preceding clauses, wherein the first circuit breaker includes a user accessible actuator.
7. The power distribution unit of clause 6, wherein the user accessible actuator is configured in a first position to indicate a closed circuit.
8. The power distribution unit of clause 7, wherein the user accessible actuator is configured in a second position to indicate an open circuit.
9. The power distribution unit of clause 8, wherein the user accessible actuator is configured in a third position to indicate a reset position.
10. The power distribution unit of clause 1, wherein the breaker mount further includes a first mounting hole.
11. The power distribution unit of clause 10, wherein the breaker mount further includes a second mounting hole.
12. The power distribution unit of clause 11, wherein the front panel of the enclosure includes a plurality of mounting locations.
13. The power distribution unit of clause 12, wherein the first mounting hole and the second mounting hole are configured to be mounted to the mounting locations by a fastening apparatus.
14. A breaker mount for mounting a circuit breaker to a front panel of a power distribution unit, the breaker mount comprising:
   a base, comprising:
      a left mounting tab;
      a right mounting tab;
      a left mounting hole;
      a right mounting hole;
      a base connection piece that connects the left mounting tab and the right mounting tab; and
      a base cavity, wherein the base cavity is configured to allow for cooling of the circuit breaker;
   a mounting surface, comprising:
      a first mounting post; and
      a second mounting post, wherein the first mounting post and the second mounting post are parallel to each other and configured to resemble a DIN-Rail mounting surface; and
      a mounting cavity, wherein the mounting cavity is configured to allow for cooling of the circuit breaker;
   a top surface, comprising:
      a top cavity, wherein the top cavity is configured to allow for cooling of the circuit breaker; and
      a top mounting tab, wherein the top mounting tab extends perpendicularly from the top surface; and
      a top mounting hole.
15. The breaker mount of clause 14, wherein the left mounting tab extends outwardly from the base connection piece.
16. The breaker mount of clause 15, wherein the right mounting tab extends outwardly from the base connection piece.
17. The circuit breaker of clause 14, wherein the circuit breaker is a one pole circuit breaker.
18. The circuit breaker of clause 14, wherein the circuit breaker is a two-pole circuit breaker.
19. A method for distributing power, comprising:
   providing an enclosure with a front panel, at least one side panel, and a rear panel;
   mounting at least one power output receptacle on the enclosure; and
   coupling at least one or more circuit breakers to a breaker mount, wherein the breaker mount is coupled to the front panel of the enclosure.
20. The method of clause 19, wherein the at least one or more circuit breakers is a DIN-Rail mount circuit breaker.

Although the subject matter has been described in language specific to structural features and/or methodological acts, it is to be understood that the subject matter defined in the appended claims is not necessarily limited to the specific features or acts described above. Rather, the specific features and acts described above are disclosed as example forms of implementing the claims.

## Claims

1. A power distribution unit comprising:
an enclosure, comprising:
a front panel;
a first power output receptacle mounted on the enclosure; wherein
a first circuit breaker mount is coupled to the front panel of the enclosure.

2. The PDU of claim 1 wherein the first circuit breaker mount includes a mounting surface comprising a first mounting post and a second mounting post wherein the first and second mounting posts are spaced apart.

3. The PDU of Claim 1 or 2 wherein the first and second mounting posts are spaced apart to receive a circuit breaker having a standard DIN-Rail mount.

4. The PDU of claim 2 or claim 3 when dependent upon claim 2, wherein the mounting surface further includes a mounting cavity formed by the space between the first and second mounting posts.

5. The power distribution unit of any one of the preceding claims, further including a first circuit breaker electrically coupled to the first power output receptacle, the first circuit breaker being physically coupled to first circuit breaker mount.

6. The power distribution unit of Claim 2, or any one of Claims 3-5 when dependent upon claim 2, wherein the first circuit breaker includes a user accessible actuator.

7. The power distribution unit of claim 6, wherein the user accessible actuator is configured in a first position to indicate a closed circuit.

8. The power distribution unit of claim 6 or Claim 7, wherein the user accessible actuator is configured in a second position to indicate an open circuit.

9. The power distribution unit of any one of claims 6-8, wherein the user accessible actuator is configured in a third position to indicate a reset position.

10. The power distribution unit of claim 5, wherein the breaker mount further includes a first mounting hole.

11. The power distribution unit of claim 10, wherein the breaker mount further includes a second mounting hole.

12. The power distribution unit of any one of the preceding claims, wherein the front panel of the enclosure includes a plurality of mounting locations.

13. The power distribution unit of claim 11, wherein the first mounting hole and the second mounting hole are configured to be mounted to the mounting locations by a fastening apparatus.

14. A breaker mount for mounting a circuit breaker to a front panel of a power distribution unit, the breaker mount comprising:
a base, comprising:
a left mounting tab;
a right mounting tab;
a left mounting hole;
a right mounting hole;
a base connection piece that connects the left mounting tab and the right mounting tab; and
a base cavity, wherein the base cavity is configured to allow for cooling of the circuit breaker;
a mounting surface, comprising:
a first mounting post; and
a second mounting post, wherein the first mounting post and the second mounting post are parallel to each other and configured to resemble a DIN-Rail mounting surface; and
a mounting cavity, wherein the mounting cavity is configured to allow for cooling of the circuit breaker;
a top surface, comprising:
a top cavity, wherein the top cavity is configured to allow for cooling of the circuit breaker; and
a top mounting tab, wherein the top mounting tab extends perpendicularly from the top surface; and
a top mounting hole.

15. The breaker mount of claim 14, wherein the left mounting tab extends outwardly from the base connection piece.

16. The breaker mount of claim 14 or Claim 15, wherein the right mounting tab extends outwardly from the base connection piece.

17. The circuit breaker of any one of Claims 14-16, wherein the circuit breaker is a one pole circuit breaker.

18. The circuit breaker of any one of Claims 14-16, wherein the circuit breaker is a two-pole circuit breaker.

19. A method for distributing power, comprising:
providing an enclosure with a front panel, at least one side panel, and a rear panel;
mounting at least one power output receptacle on the enclosure; and
coupling at least one or more circuit breakers to a breaker mount, wherein the breaker mount is coupled to the front panel of the enclosure.

20. The method of claim 19, wherein the at least one or more circuit breakers is a DIN-Rail mount circuit breaker.
